# EUROPEAN PATENT SPECIFICATION

(11) **EP 0 333 447 B1**
(45) Date of publication and mention of the grant of the patent: **07.09.1994**
(21) Application number: 89302524.7
(22) Date of filing: 15.03.1989
(51) Int. Cl.: H01L 21/28, H01L 29/10, H01L 29/72, H01L 29/78

(54) **Method of manufacturing a MOS type semiconductor device**
Verfahren zur Herstellung eines MOS-Typ-Halbleiter-Bauelement
Méthode de fabrication d'un dispositif semi-conducteur du type MOS

(30) Priority: 18.03.1988 JP 65423/88
(43) Date of publication of application: 20.09.1989
(73) Proprietor: FUJI ELECTRIC CO., LTD., Kawasaki-shi Kanagawa 210 (JP)
(72) Inventor: Fujihira, Tatsuhiko, Kawasaki-ku Kawasaki-shi Kanagawa (JP)
(74) Representative: Stebbing, Timothy Charles

(56) References cited:
- EP-A- 0 244 366
- DE-A- 3 634 982
- DE-A- 3 711 033
- US-A- 4 430 792
- PATENT ABSTRACTS OF JAPAN, vol. 10, no. 27 (E-378)[2084], 4th February 1986 ; & JP-A-60 186 068
- PATENT ABSTRACTS OF JAPAN, vol. 10, no. 359 (E-460)[2416], 3rd December 1986 ; & JP-A-61 156 882

## Description

The present invention relates to
a MOS type semiconductor device such as a power MOSFET, insulated gate type bipolar transistor, etc., and to a method of manufacturing the same.

As a MOS type semiconductor device, a power MOSFET utilizing only majority carriers is known. Also, an insulated gate bipolar transistor (called an IGBT, IGT or COMFET) utilizing a conduction modulation caused by two kinds of carriers, that is, electrons and holes is known.

One example of this type of semiconductor device is disclosed in U.S. Patent No. 4,672,407 or No. 4,587,713.

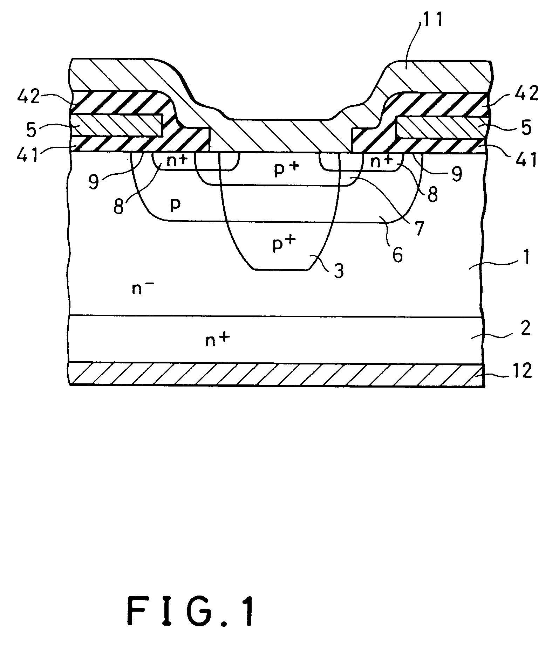

Fig. 1 is a cross-sectional view showing a power MOSFET already proposed and generally, it is manufactured by the following process steps. At first, a p⁺ type diffused region 3 is formed in a surface of an n⁻ type high resistivity layer 1 which constitutes a semiconductor substrate with an n⁺ type low resistivity layer 2. Next, after forming a gate electrode 5 on the same surface of the n⁻ type high resistivity layer 1 via a gate insulating film 41, an opening is formed in the gate electrode 5 by a photo-lithography method. An impurity diffusion for forming a p type base layer 6 is conducted by using the gate electrode 5 having the opening as a mask, and a p⁺ type low resistivity region 7 is formed in the p type base layer 6 by photo-lithography and diffusion process steps.

Thereafter, by using again the gate electrode 5 as a part of a mask, an n⁺ type source layer 8 is formed, and the surfaces are covered by an insulating film 42. After forming a contact hole in the insulating film 42, a source electrode 11 is formed, and also a drain electrode 12 contacted to the n⁺ type low resistivity layer 2 is formed.

In the semiconductor device thus constructed, when a positive voltage is applied to the gate electrode as compared to the source electrode 11, a channel 9 is produced in a surface of the p type base layer 6 just under the gate insulating film 41, thereby causing a conductive state by injecting electrons into the drain layer consisting of the high resistivity layer 1 and the low resistivity layer 2 from the n⁺ type source layer 8 through the channel 9, and when the potential of the gate electrode 5 is maintained to the same potential of the source electrode 11 or a negative voltage is applied as compared to the source electrode 11, a non-conductive state is caused. Therefore, the above-described device operates as a switching element.

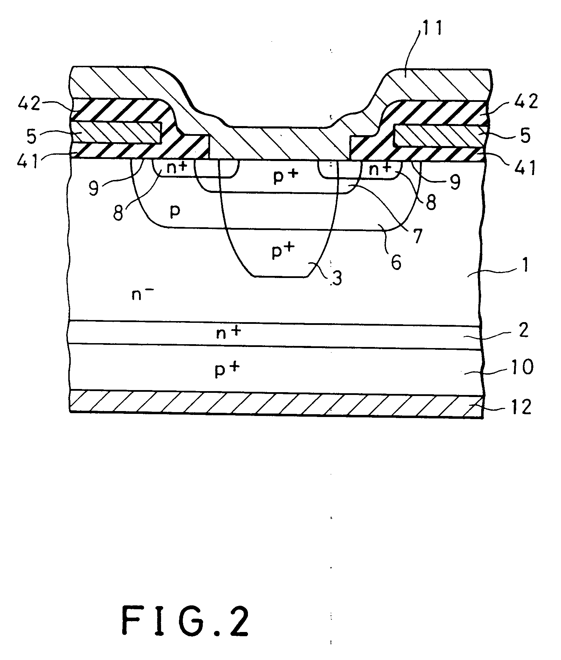

Fig. 2 shows an insulated gate type bipolar transistor (IGBT) already proposed. The IGBT can be manufactured by using a semiconductor substrate consisting of a p⁺ type drain layer 10, an n⁺ type buffer layer 2 and an n⁻ type high resistivity layer 1, through the same process steps as in the power MOSFET. The difference of the IGBT from the power MOSFET is as follows. When electrons are injected into the p⁺ type drain layer 10 from the n+ type source layer 8 through the channel 9, the n⁻ type high resistivity layer 1 and the n⁺ type buffer layer 2 because the drain layer 10 is of p⁺ type layer, holes are injected into the n⁻ type high resistivity layer 1 from the p⁺ type drain layer 10, in response to the injection of electrons, through the n⁺ type buffer layer 2, and therefore, the n⁻ type high resistivity layer 1 changes its electrical conductance so as to be a low resistance state.

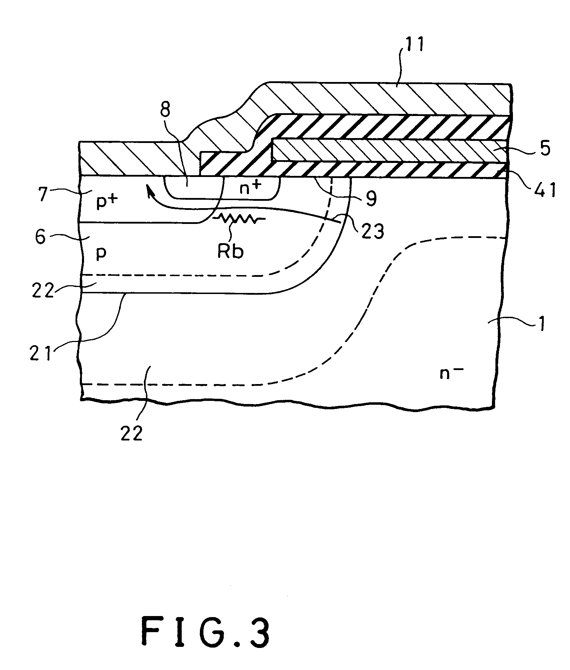

When the MOSFET shown in Fig. 1 is turned off under a condition of connecting an inductive load as in an inverter circuit etc., device destruction is sometimes caused. The reason for the destruction will be explained by referring to Fig. 3. When the MOSFET is turned off under the inductive load, a depletion layer 22 is promptly produced at both sides of the PN junction 21. Some of the carriers emitted at this time flow in a portion of the p type base layer 6 under the n⁺ type source layer 8 as a hole current 23. Because the surface of the p type base layer 6 and the n⁺ type source layer 8 are short-circuited to each other by the source electrode 11, a potential difference calculated by multiplying the hole current 23 by a base resistance Rb is produced between the n⁺ type source layer 8 and the p type base layer 6. If the potential difference exceeds a built-in voltage between base-source, a parasitic transistor consisting of the n⁺ type source layer 8, the p type base layer 6 and the n⁻ type high resistivity layer 1 becomes ON state by injecting electrons from the source layer 8, thereby the device is destroyed.

An object of forming the p⁺ type diffused layer 3 is to prevent the device destruction due to the turning ON of the parasitic transistor, by reducing the hole current 23 flowing under the n⁺ type source layer 8.

An object of forming the p⁺ type low resistivity layer 7 is surely to prevent the device destruction due to the turning ON of the parasitic transistor, that is, it is intended to decrease the base resistance Rb mentioned above for preventing the turning ON of the parasitic transistor.

However, a sufficient turn-off capability of the power MOSFET under an inductive load is not obtained even though these countermeasures are taken to meet the situation.

In the case of the IGBT shown in Fig. 2, device destruction is sometimes caused by the turning ON of the parasitic transistor consisting of the n+ type source layer 8, the p type base layer 6 and the n- type high resistivity layer 1 when a turn-off operation under an inductive load is done, as with a power MOSFET. A further difficult problem is that a hole current 23 flowing under the n+ type source layer 8 exists, even in a normal ON state operation. Therefore, the IGBT is sometimes destroyed by the turning ON of the parasitic transistor, even in a turn-off operation without an inductive load or in the normal ON state operation. In the case of the IGBT as well as the power MOSFET, efforts have been made to prevent the ON state of the parasitic transistor by providing the p+ type diffused layer 3 and p+ type low resistivity layer 7. However, the results have not been adequate.

It is therefore desirable to provide a MOS type semiconductor device having a large turn-off capability by surely preventing the operation of the parasitic transistor at a lower cost, and to provide a manufacturing method therefor.

EP-A-0 244 366 discloses a method for manufacturing a MOS type semiconductor device according to the preamble of accompanying claims 1 and 2.

JP-A-61-156882 discloses a double-diffused IGFET structure which is intended to prevent the turning on of a parasitic transistor, generally corresponding to the prior art of Fig. 1 as described above.

According to a first aspect of the present invention, there is provided a method of manufacturing a MOS type semiconductor device, the device comprising:-
a drain layer of a first conductivity type, a high resistivity layer formed on said drain layer, and a base layer of a second conductivity type formed in said high resistivity layer;
a base layer region of said second conductivity type, and a source layer region of said first conductivity type, both formed in the surface portion of said base layer, said base layer region being positioned at a center region of the surface of said base layer, and said base layer region and said source layer region being partially overlapped;
a channel forming region formed in the surface portion of said base layer between said source layer region and said high resistivity layer and having a gate insulating film thereon; and
a gate electrode formed over said channel forming region and on said gate insulating film;
said method comprising the steps of:-
(a) forming said base layer by diffusing impurities into said high resistivity layer by using said gate electrode as a mask;
(b) forming an insulation layer on said gate electrode and said base layer;
(c) forming said base layer region by implanting impurity ions into said base layer by using said insulation layer formed on said gate electrode as a mask;
(d) forming a resist mask on part of said base layer region; and
(e) forming said source layer region by implanting impurity ions into said base layer region by using at least said resist as a mask and diffusing said impurity ions after the removal of said resist;

characterised in that said insulation layer is formed at the same time as the diffusion of said base layer, the ion implantation for forming said base layer region being performed through said insulation layer formed on said base layer; and in that
prior to step (d), said insulation layer is thinned by isotropic etching, and in said step (e), said impurity ions are implanted through the thinned insulation layer and said gate electrode is also used as a mask.

According to a second aspect of the present invention, there is provided a method of manufacturing a MOS type semiconductor device, the device comprising:-
a drain layer of a first conductivity type, a high resistivity layer formed on said drain layer, and a base layer of a second conductivity type formed in said high resistivity layer;
a base layer region of said second conductivity type and a source layer region of said first conductivity type, both formed in the surface portion of said base layer, said base layer region being positioned at a center region of the surface of said base layer and said base layer region and said source layer region being partially overlapped;
a channel forming region formed in the surface portion of said base layer between said source layer region and said high resistivity layer and having a gate insulating film thereon; and
a gate electrode formed over said channel forming region and on said gate insulating film;
said method comprising the steps of:-
(a) forming said base layer by diffusing impurities into said high resistivity layer by using said gate electrode as a mask;
(b) forming said base layer region by implanting impurity ions into said base layer by using said gate electrode as a mask;
(c) forming a resist mask on part of said base layer region; and
(d) forming said source layer region by implanting impurity ions into said base layer region by using at least said resist as a mask;

characterized in that, prior to said step (c), said gate electrode is isotropically etched to thin the thickness and reduce a portion thereof overlapping said base layer region; and in that in said step, said thinned gate electrode is also used as a mask.

Thus, in methods of the present invention, both the base layer region of the second conductivity type having a high impurity concentration and the source layer region of the first conductivity type having a high impurity concentration are formed by self-alignment by using as a mask (after thinning by isotropic etching) the gate electrode or an oxide layer thereon. Therefore, an edge of the low resistivity base layer region can be precisely positioned near an edge of the source layer region, facing the channel side. Consequently, the parasitic transistor is substantially prevented from turning ON because of its greatly reduced base resistance.

Reference is made, by way of example, to the accompanying drawings, in which:-
Fig. 1 is a cross-sectional view showing an example of a prior-proposed power MOSFET;
Fig. 2 is a cross-sectional view showing an example of a prior-proposed IGBT;
Fig. 3 is a cross-sectional view showing a problem involved in the prior-proposed MOS type semiconductor device;
Figs. 4A-4D are cross-sectional views showing a part of process steps according to one embodiment of the present invention; and
Figs. 5A-5D are cross-sectional views showing a part of process steps according to another embodiment of the invention.

Hereinafter, embodiments of the present invention will be described with reference to the drawings.

Figs. 4A-4D show process steps in one embodiment of the present invention, and the same components as those in Fig. 1 and Fig. 2 are indicated by the same reference numerals. At first, an oxide layer 40 is grown when the p type base layer 6 is formed by diffusion. Next, ion implantation of, for example, boron ions is conducted with a proper energy (Fig. 4A).

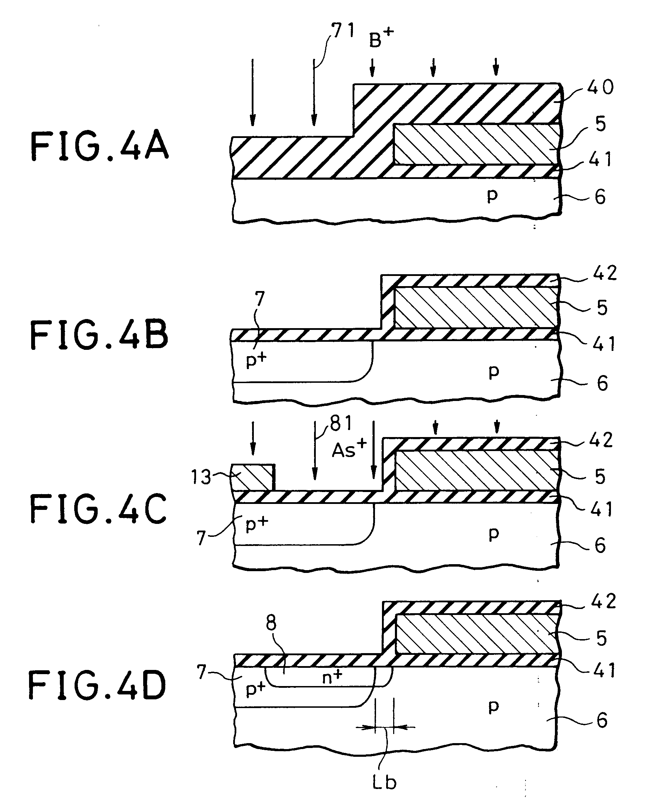

Next, the p⁺ type low resistivity layer 7 is formed by annealing heat treatment, then the oxide layer 40 is thinned by isotropic etching (Fig. 4B).

Thereafter, a resist mask 13 is formed by photo-lithography, and ion implantation of, for example, arsenic ions is conducted with a proper energy (Fig. 4C), then after removing the resist mask 13, the n⁺ type source layer 8 is formed by annealing heat treatment (Fig. 4D).

Through above-described process steps, a distance Lb between an edge of the p⁺ type low resistivity layer 7 and an edge of the n⁺ type source layer 8 facing to the channel side can become small such a value as one tenth or less comparing to existing manufacturing process steps, thereby reducing greatly the base resistance Rb (refer to Fig. 3) and hardly rendering (greatly reducing) turning ON of the parasitic transistor. Further, the photo-lithography process step
for forming the p⁺ type low resistivity layer 3 shown in Figs. 1 and 2 can be omitted. Therefore, a semiconductor device with high performance can be provided at a low cost.

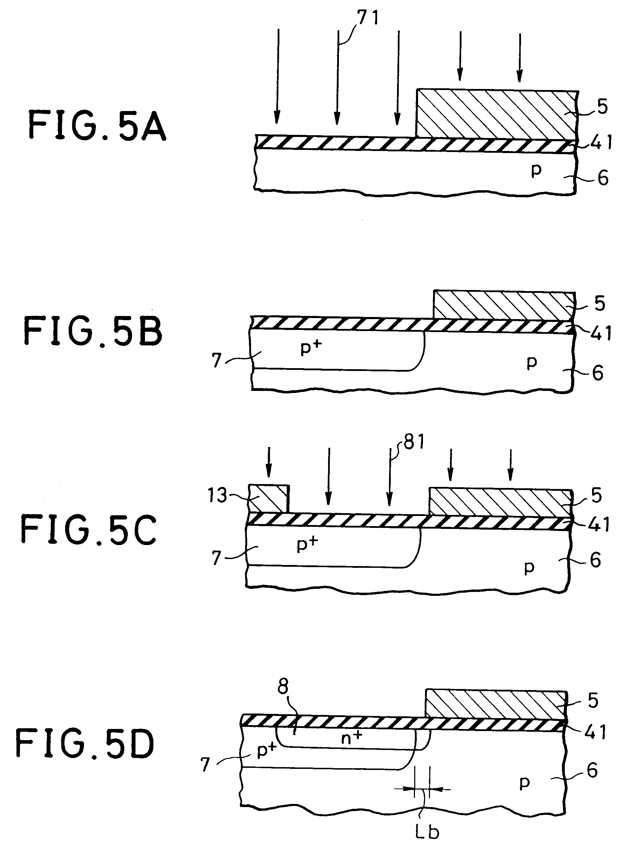

Figs. 5A-5D show another embodiment. This embodiment is also an n channel MOS type semiconductor device. In this case, at first, a thicker gate electrode 5 is formed. After forming an opening in the gate electrode 5 by photo-lithography and diffusing for the p type base layer 6, ion implantation of, for example, boron ions 71 is conducted with a proper energy (Fig. 5A).

Next, the p⁺ type low resistivity layer 7 is formed in the p type base layer 6 through an annealing heat treatment. The gate electrode 5 is isotropically etched to thin the thickness, and the gate electrode 5 is also etched to reduce a overlapping region to the p⁺ type low resistivity region 7 (Fig. 5B).

Next, a resist mask 13 is formed by photo-lithography, and ion implantation of, for example, arsenic ions is conducted with a proper energy (Fig. 5C).

Next, after removing the resist mask 13, the n⁺ type source layer 8 is formed through annealing heat treatment (Fig. 5D).

Through these process steps, as in the previous embodiment, a distance Lb between an edge of the p⁺ type low resistivity layer 7 and an edge of the n⁺ type source layer 8 facing to the channel side can become small such a value as one tenth or less comparing to existing manufacturing process steps, thereby reducing greatly the base resistance Rb (refer to Fig. 3) and greatly reducing turning ON of the parasitic transistor. Further, the photo-lithography process step for forming the p⁺ type low resistivity layer 7 in the prior process can be omitted. Therefore, a semiconductor device with high performance can be provided at a low cost.

Although the above-described embodiments concern only an n channel type device, of course, the present invention can be applicable also to a p channel type device, and also to MOS type semiconductor devices other than the power MOSFET or IGBT.

As will be clear from the above, the present invention can provide a MOS type semiconductor device and a manufacturing method therefor, in which the device has a drain layer of a first conductivity type, and a base layer of a second conductivity type formed in a surface portion of the drain layer. The base layer includes a source layer region of the first conductivity type having a high impurity concentration, and a base layer region of the second conductivity type also having a high impurity concentration. The base layer region is located at a side portion remote from the drain layer, this side portion being contained in a region in which the source region is located. A channel forming region is interposed between the source layer region and the drain layer, and the device also includes a gate electrode formed on the channel forming region via a gate insulating film, together with a source electrode contacted to the source and base layer regions. The manufacturing method of the device features a step of forming the base layer region and source layer region in each case by introducing impurities sequentially using the gate electrode as a mask.

Thus, in embodiments of the invention, both the base layer region of the second conductivity type having a high impurity concentration, and the source layer region of the first conductivity type having a high impurity concentration, are formed in a self-alignment manner using the gate electrode as a mask, and therefore, an edge of the low resistivity base layer region can be precisely positioned near an edge of the source layer region facing the channel side. Consequently, the parasitic transistor consisting of the source layer, the base layer and the drain layer is greatly reduced in its base resistance. Therefore, the parasitic transistor is inhibited from turning ON, thereby eliminating the device destruction and enhancing the current turn-off capability in the MOS type semiconductor device. Moreover, one photo-lithography process step can be omitted by adopting the self-alignment manner, and therefore, a device having high performance can be manufactured at a low cost.

## Claims

1. A method of manufacturing a MOS type semiconductor device, the device comprising:-
a drain layer (2) of a first conductivity type, a high resistivity layer (1) formed on said drain layer, and a base layer (6) of a second conductivity type formed in said high resistivity layer (1);
a base layer region (7) of said second conductivity type, and a source layer region (8) of said first conductivity type, both formed in the surface portion of said base layer (6), said base layer region (7) being positioned at a center region of the surface of said base layer (6), and said base layer region (7) and said source layer region (8) being partially overlapped;
a channel forming region formed in the surface portion of said base layer (6) between said source layer region (8) and said high resistivity layer (1) and having a gate insulating film thereon; and
a gate electrode (5) formed over said channel forming region and on said gate insulating film;
said method comprising the-steps of:-
(a) forming said base layer (6) by diffusing impurities into said high resistivity layer (1) by using said gate electrode (5) as a mask;
(b) forming an insulation layer (40) on said gate electrode (5) and said base layer (6);
(c) forming said base layer region (7) by implanting impurity ions into said base layer (6) by using said insulation layer (40) formed on said gate electrode (5) as a mask;
(d) forming a resist mask (13) on part of said base layer region (7); and
(e) forming said source layer region (8) by implanting impurity ions into said base layer region (7) by using at least said resist (13) as a mask and diffusing said impurity ions after the removal of said resist (13);
characterised in that said insulation layer (40) is formed at the same time as the diffusion of said base layer (6), the ion implantation for forming said base layer region (7) being performed through said insulation layer (40) formed on said base layer (6); and in that
prior to step (d), said insulation layer (40) is thinned by isotropic etching, and in said step (e), said impurity ions are implanted through the thinned insulation layer (42) and said gate electrode (5) is also used as a mask.

2. A method of manufacturing a MOS type semiconductor device, the device comprising:-
a drain layer (2) of a first conductivity type, a high resistivity layer (1) formed on said drain layer, and a base layer (6) of a second conductivity type formed in said high resistivity layer (1);
a base layer region (7) of said second conductivity type and a source layer region (8) of said first conductivity type, both formed in the surface portion of said base layer (6), said base layer region (7) being positioned at a center region of the surface of said base layer (6) and said base layer region (7) and said source layer region (8) being partially overlapped;
a channel forming region formed in the surface portion of said base layer (6) between said source layer region (8) and said high resistivity layer (1) and having a gate insulating film thereon; and
a gate electrode (5) formed over said channel forming region and on said gate insulating film;
said method comprising the steps of:-
(a) forming said base layer (6) by diffusing impurities into said high resistivity layer (1) by using said gate electrode (5) as a mask;
(b) forming said base layer region (7) by implanting impurity ions into said base layer (6) by using said gate electrode (5) as a mask;
(c) forming a resist mask (13) on part of said base layer region (7); and
(d) forming said source layer region (8) by implanting impurity ions into said base layer region (7) by using at least said resist (13) as a mask;
characterized in that, prior to said step (c), said gate electrode (5) is isotropically etched to thin the thickness and reduce a portion thereof overlapping said base layer region (7); and in that in said step (d), said thinned gate electrode (5) is also used as a mask.

## Patentansprüche

1. Verfahren zur Herstellung eines MOS-Typ-Halbleiter-Bauelements, enthaltend:
eine Drainschicht (2) eines ersten Leitfähigkeitstyps, eine auf der Drainschicht gebildete Hochwiderstandsschicht (1), und eine in der Hochwiderstandsschicht (1) gebildete Basisschicht (6) eines zweiten Leitfähigkeitstyps;
einen Basisschichtbereich (7) des zweiten Leitfähigkeitstyps und einen Sourceschichtbereich (8) des ersten Leitfähigkeitstyps, die beide in dem Oberflächenabschnitt der Basisschicht (6) gebildet sind, welcher Basisschichtbereich (7) bei einem Mittenbereich der Oberfläche der Basisschicht (6) angeordnet ist, und sich der Basisschichtbereich (7) und der Sourceschichtbereich (8) teilweise überlappen;
einen in dem Oberflächenabschnitt der Basisschicht (6) zwischen dem Sourceschichtbereich (8) und der Hochwiderstandsschicht (1) gebildeten Kanalbildungsbereich, welcher einen darauf gebildeten Gateisolierfilm aufweist; und
eine oberhalb des Kanalbildungsbereiches und auf dem Gateisolierfilm gebildete Gateelektrode (5);
wobei das Verfahren die Schritte aufweist:
(a) Bilden der Basisschicht (6) durch Diffundieren von Verunreinigungen in die Hochwiderstandsschicht (1) unter Verwendung der Gateelektrode (5) als Maske;
(b) Bilden einer Isolierschicht (40) auf der Gateelekrode (5) und der Basisschicht (6);
(c) Bilden des Basisschichtbereiches (7) durch Implantieren von Verunreinigungsionen in die Basisschicht (6) unter Verwendung der auf der Gateelektrode (5) gebildeten Isolierschicht (40) als Maske;
(d) Bilden einer Abdeckmaske (13) auf einem Teil des Basisschichtbereiches (7); und
(e) Bilden des Sourceschichtbereiches (8) durch Implantieren von Verunreinigungsionen in den Basisschichtbereich (7) unter Verwendung von zumindest der Abdeckschicht (13) als Maske und Diffundieren der Verunreinigungsionen nach der Entfernung der Abdeckschicht (13);
dadurch gekennzeichnet, daß die Isolierschicht (40) gleichzeitig mit der Diffusion der Basisschicht (6) gebildet wird, die Ionenimplantation zur Bildung des Basisschichtbereiches (7) über die auf der Basisschicht (6) gebildete Isolierschicht (40) durchgeführt wird; und daß
vor dem Schritt (d) die Isolierschicht (40) durch isotropes Ätzen verdünnt wird, und bei dem Schritt (e) die Verunreinigungsionen über die verdünnte Isolierschicht (42) implantiert werden, und die Gateelektrode (5) ebenfalls als Maske verwendet wird.

2. Verfahren zur Herstellung eines MOS-Typ-Halbleiter-Bauelements, enthaltend:
eine Drainschicht (2) eines ersten Leitfähigkeitstyps, eine auf der Drainschicht gebildete Hochwiderstandsschicht (1), und eine in der Hochwiderstandsschicht (1) gebildete Basisschicht (6) eines zweiten Leitfähigkeitstyps;
einen Basisschichtbereich (7) des zweiten Leitfähigkeitstyps und einen Sourceschichtbereich (8) des ersten Leitfähigkeitstyps, die beide in dem Oberflächenabschnitt der Basisschicht (6) gebildet sind, welcher Basisschichtbereich (7) bei einem Mittenbereich der Oberfläche der Basisschicht (6) angeordnet ist, und sich der Basisschichtbereich (7) und der Sourceschichtbereich (8) teilweise überlappen;
einen in dem Oberflächenabschnitt der Basisschicht (6) zwischen dem Sourceschichtbereich (8) und der Hochwiderstandsschicht (1) gebildeten Kanalbildungsbereich, welcher einen darauf gebildeten Gateisolierfilm aufweist; und
eine oberhalb des Kanalbildungsbereiches und auf dem Gateisolierfilm gebildete Gateelektrode (5);
wobei das Verfahren die Schritte aufweist:
(a) Bilden der Basisschicht (6) durch Diffundieren von Verunreinigungen in die Hochwiderstandsschicht (1) unter Verwendung der Gateelektrode (5) als Maske;
(b) Bilden des Basisschichtbereiches (7) durch Implantieren von Verunreinigungsionen in die Basisschicht (6) unter Verwendung der Gateelektrode (5) als Maske;
(c) Bilden einer Abdeckmaske (13) auf einem Teil des Basisschichtbereiches (7); und
(d) Bilden des Sourceschichtbereiches (8) durch Implantieren von Verunreinigungsionen in den Basisschichtbereich (7) unter Verwendung von zumindest der Abdeckung (13) als Maske;
dadurch gekennzeichnet, daß vor dem Schritt (c) die Gateelektrode (5) zur Verdünnung der Dicke und Verringerung eines Abschnittes davon, der den Basisschichtbereich (7) überlappt, isotrop geätzt wird; und daß bei dem Schritt (d) die verdünnte Gateelektrode (5) ebenfalls als Maske verwendet wird.

## Revendications

1. Procédé de fabrication d'un composant semi-conducteur du type MOS, le composant comprenant:
une couche de drain (2) d'un premier type de conductivité, une couche à haute résistivité (1) formée sur ladite couche de drain, et une couche de base (6) d'un deuxième type de conductivité formée dans ladite couche à haute résistivité (1);
une région (7) de couche de base dudit deuxième type de conductivité, et une région (8) de couche de source dudit premier type de conductivité, formées l'une et l'autre dans la partie superficielle de ladite couche de base (6), ladite région (7) de couche de base étant positionnée dans une région centrale de la surface de ladite couche de base (6), et ladite région (7) de couche de base et ladite région (8) de couche de source se recouvrant partiellement;
une région de formation de canal, formée dans la partie superficielle de ladite couche de base (6) entre ladite région (8) de couche de source et ladite couche à haute résistivité (1) et portant une pellicule isolante de grille; et
une électrode de grille (5) formée au-dessus de ladite région de formation de canal et sur ladite pellicule d'isolation de grille;
ledit procédé comprenant les étapes consistant à:
(a) former ladite couche de base (6) en diffusant des impuretés dans ladite couche à haute résistivité (1) en utilisant comme masque ladite électrode de grille (5);
(b) former une couche d'isolation (40) sur ladite électrode de grille (5) et ladite couche de base (6);
(c) former ladite région (7) de couche de base en implantant des ions d'impuretés dans ladite couche de base (6) en utilisant comme masque ladite couche d'isolation (40) formée sur ladite électrode de grille (5);
(d) former un masque de résine (13) sur une partie de ladite région (7) de couche de base; et
(e) former ladite région (8) de couche de source en implantant des ions d'impuretés dans ladite région (7) de couche de base en utilisant au moins une résine (13) comme masque et en diffusant lesdits ions d'impuretés après l'enlèvement de ladite résine (13);
caractérisé en ce que ladite couche d'isolation (40) est formée en même temps que la diffusion de ladite couche de base (6), l'implantation d'ions qui sert à former ladite région (7) de couche de base étant effectuée à travers ladite couche d'isolation (40) formée sur ladite couche de base (6); et en ce que
avant l'étape (d), ladite couche d'isolation (40) est amincie par attaque isotrope et, à l'étape (e), lesdits ions d'impuretés sont implantés au travers de ladite couche d'isolation amincie (42) et ladite électrode de grille (5) est également utilisée comme masque.

2. Procédé de fabrication d'un composant semi-conducteur du type MOS, le composant comprenant:
une couche de drain (2) d'un premier type de conductivité, une couche à haute résistivité (1) formée sur ladite couche de drain, et une couche de base (6) d'un deuxième type de conductivité formée dans ladite couche à haute résistivité (1);
une région (7) de couche de base dudit deuxième type de conductivité, et une région (8) de couche de source dudit premier type de conductivité, formées l'une et l'autre dans la partie superficielle de ladite couche de base (6), ladite région (7) de couche de base étant positionnée dans une région centrale de la surface de ladite couche de base (6), et ladite région (7) de couche de base et ladite région (8) de couche de source se recouvrant partiellement;
une région de formation de canal, formée dans la partie superficielle de ladite couche de base (6) entre ladite région (8) de couche de source et ladite couche à haute résistivité (1) et portant une pellicule isolante de grille; et
une électrode de grille (5) formée au-dessus de ladite région de formation de canal et sur ledit film d'isolation de grille;
ledit procédé comprenant les étapes consistant à:
(a) former ladite couche de base (6) en diffusant des impuretés dans ladite couche à haute résistivité (1 ) en utilisant comme masque ladite électrode de grille (5);
(b) former ladite région (7) de couche de base en implantant des ions d'impuretés dans ladite couche de base (6) en utilisant comme masque ladite électrode de grille (5);
(c) former un masque de résine (13) sur une partie de ladite région (7) de couche de base; et
(d) former ladite région (8) de couche de source en implantant des ions d'impuretés dans ladite région (7) de couche de base en utilisant comme masque au moins ladite résine (13);
caractérisé en ce que, avant ladite étape (c), ladite électrode de grille (5) est attaquée de façon isotrope afin de diminuer l'épaisseur et de réduire une partie de celle-ci qui recouvre ladite région (7) de couche de base; et en ce que, à ladite étape (d), ladite électrode de grille amincie (5) est également utilisée comme masque.
